# FASCICULE DE BREVET EUROPEEN

(11) **EP 0 309 322 B1**
(45) Date de publication et mention de la délivrance du brevet: **17.01.1996**
(21) Numéro de dépôt: 88402334.2
(22) Date de dépôt: 16.09.1988
(51) Int. Cl.: H01L 39/24

(54) **Matériaux supraconducteurs et leur procédé de préparation**
Supraleitende Materialien und Verfahren um sie herzustellen
Superconducting materials and process of manufacturing

(30) Priorité: 18.09.1987 FR 8712934
(43) Date de publication de la demande: 29.03.1989
(73) Titulaire: RHONE-POULENC CHIMIE, F-92408 Courbevoie Cédex (FR)
(72) Inventeur: Lafon, Marie-Odile, F-75004 Paris (FR); Magnier, Claude, F-75019 Paris (FR)
(74) Mandataire: Dubruc, Philippe

(56) Documents cités:
- EP-A- 0 122 665
- GB-A- 2 017 523
- ADVANCED CERAMIC MATERIALS - CREAMIC SUPERCONDUCTORS, vol. 2, no. 3B, juillet 1987, pp. 444-456, Westerville, US ; G.W. CRABTREE et al. : "Fabrication mechanical properties, heat capacity, oxygen diffusion, and the effect of alkalic earth ion substitution on high Tc superconductors"
- NATURE, vol. 328, août 1987, pp. 786-787 ; D.N. MATTHEWS et al. : "Increased transition temperatures in YBa2Cu30y superconducting ceramics by exposure to nitrogen"

## Description

La présente invention a trait au domaine des matériaux supraconducteurs.

On sait que la supraconductivité se caractérise entre autre par la disparition de toute résistance électrique dans un corps porté à très basse température.

Jusqu'à un passé récent, l'état supraconducteur dans certains matériaux n'apparaissait qu'en-dessous d'une température seuil, dite "température critique", généralement proche du zéro absolu. Une telle contrainte a constitué à l'évidence un frein sérieux au développement sur une grande échelle de toutes les applications pratiques potentielles pouvant découler de la supraconductivité.

Or, depuis peu, des recherches ont permis de mettre en évidence de nouveaux matériaux qui présentent des propriétés supraconductrices à plus hautes températures, c'est-à-dire des températures s'étalant de 70 à 90 K, voire jusqu'à 100 K.

Ces matériaux sont pour la plupart à base de terres rares, d'alcalino-terreux, de métaux de transition et d'oxygène. Plus spécifiquement, les systèmes étudiés les plus prometteurs semblent être ceux à base d'yttrium et/ou lanthane, de baryum et/ou de strontium et/ou de calcium, de cuivre et/ou de nickel et/ou de cobalt et/ou de manganèse, et d'oxygène.

La méthode de synthèse généralement décrite dans la littérature pour aboutir à ces matériaux repose sur une réaction en phase solide, à hautes températures (1 000°C), entre des oxydes et/ou des sels contenant un anion volatil (par exemple le carbonate) des éléments correspondants, ces derniers composés se présentant sous forme de poudres.

Toutefois, ce procédé présente l'inconvénient d'être d'un contrôle délicat et conduit à des poudres dont l'aptitude au frittage peut paraître insuffisante.

Or, au niveau de certaines applications pratiques, seule l'utilisation des produits frittés supraconducteurs présente un intérêt réel.

Il est donc essentiel de pouvoir disposer de matériaux frittés, denses et homogènes, ayant conservé les propriétés intrinsèques de supraconductivité des poudres de départ. Il en découle la nécessité de disposer tout d'abord de poudres supraconductrices homogènes présentant de bonnes aptitudes au frittage.

La présente invention a donc pour but de résoudre les problèmes ci-dessus et de proposer des moyens simples, efficaces et de mise en oeuvre aisée, pour obtenir de manière reproductible tant des poudres supraconductrices homogènes présentant une excellente aptitude au frittage que des matériaux frittés supraconducteurs de haute densité.

On a maintenant trouvé, et il s'agit là d'un des premiers objets de la présente invention, que l'on peut obtenir des poudres fines supraconductrices et frittables essentiellement à base d'au moins une terre-rare, d'au moins un alcalino-terreux, d'un métal de transition et d'oxygène, au moyen du procédé de préparation selon l'invention, ledit procédé, comprenant les étapes suivantes :
a) on prépare une solution aqueuse à base de nitrates et/ou d'acétates d'au moins une terre rare, d'au moins un alcalino-terreux et d'au moins un métal de transition ;
b) on sèche ladite solution par atomisation en injectant celle-ci suivant une trajectoire confondue avec l'axe de symétrie d'un écoulement hélicoïdal et puits-tourbillon de gaz chauds pulvérisant puis séchant la solution précitée; le temps de séjour des particules dans le réacteur étant inférieur à 1/10 de seconde environ.
c) on calcine le produit séché ;
d) on opère éventuellement le broyage de la poudre calcinée. Dans l'exposé qui suit de la présente invention, on entend par terre rare d'une part tout élément du Tableau Périodique dont le numéro atomique est compris, inclusivement, entre 57 et 71, et d'autre part l'yttrium qui, par convention, est assimilé ici à une terre rare.

Les terres rares particulièrement préférées pour la mise en oeuvre du procédé selon l'invention sont l'yttrium et le lanthane.

D'autre part, les alcalino-terreux utilisables dans le présent procédé sont principalement le calcium, le baryum et le strontium.

Enfin, les métaux de transition sont préférentiellement choisis parmi le cuivre, le nickel, le manganèse, le cobalt et le fer.

Le choix des éléments au sein des familles ci-dessus se fera bien entendu en fonction de la nature et de la composition de la poudre supraconductrice que l'on désire obtenir.

De même, les proportions entre les divers éléments au sein de la solution de départ sont ajustées classiquement en fonction de la stoechiométrie désirée dans le produit final, celle-ci devant naturellement correspondre à l'obtention des propriétés supraconductrices.

Le procédé selon l'invention s'applique ainsi particulièrement bien à la fabrication des systèmes supraconducteurs du type Y-Ba-Cu-O. Ces systèmes ont été étudiés notamment dans un article paru dans le Journal of American Chemical Society, 1987, 109, 2528-2530.

Selon l'invention, la terre rare, l'alcalino-terreux et le métal de transition sont présents dans la solution aqueuse initiale soit sous forme de nitrates soit sous forme d'acétates, soit encore sous forme d'un mélange des deux sels. Toutefois, préférentiellement, on opère avec une solution de nitrates.

A l'issue de cette étape de préparation, on procède au séchage de la solution.

Selon l'invention, on réalise ce séchage dans un réacteur "flash", par exemple du type mis au point par la Demanderesse et décrit notamment dans les brevets français n° 2 257 326, 2 419 754 et 2 431 321. Dans ce cas, les gaz traitants sont animéa d'un mouvement hélicoïdal et s'écoulent dans un puits-tourbillon. La solution est injectée suivant une trajectoire confondue avec l'axe de symétrie des trajectoires hélicoïdales des gaz, ce qui permet de transférer parfaitement la quantité de mouvement des gaz à ladite solution. Les gaz assurent ainsi une double fonction : d'une part la pulvérisation, c'est à dire la transformation en fines gouttelettes, de la solution et d'autre part le séchage des gouttelettes obtenues. Par ailleurs, le temps de séjour des particules dans le réacteur est extrêmement faible, il est inférieur à 1/10 de seconde environ, ce qui supprime tout risque de surchauffe par suite d'un contact trop long avec les gaz.

Selon les débits respectifs des gaz et de la solution, la température d'entrée des gaz est comprise entre 600°C et 900°C, de préférence comprise entre 700° et 900°, et la température de sortie du solide séché comprise entre 100°C et 300°C, de préférence entre 150°C et 250°C.

On obtient un produit sec présentant une granulométrie de l'ordre de quelques micromètres, comprise entre 1 et 10 micromètres par exemple.

Le produit est ensuite calciné.

La calcination est opérée à une température comprise entre 700°C et 1 000°C, de préférence comprise entre 850°C et 950°C. La durée de la calcination peut varier entre 30 minutes et 24 heures par exemple, et de préférence entre 5 et 15 heures.

Cette calcination est conduite sous atmosphère d'air ou tout mélange air/oxygène, mais de préférence sous air.

D'autre part, selon un mode particulier de réalisation de l'invention, les produits calcinés sont refroidis très rapidement jusqu'à température ambiante, opération équivalente à une trempe, par exemple au moyen d'un balayage d'air froid.

Le temps de refroidissement est généralement de l'ordre de quelques secondes.

A la suite de cette calcination, on obtient une poudre supraconductrice présentant une granulométrie macroscopique de 1 à 10 micromètres environ, les grains de 1 à 10 µm étant constitués de cristallites élémentaires de taille comprise entre 10 et 60 nm (100 Å et 600 Å) environ.

Les poudres obtenues doivent généralement être broyées, de préférence à sec, de manière à pouvoir conduire un bon frittage. La répartition granulométrique moyenne des poudres se situe alors entre environ 0,5 et 2 micromètres, de préférence entre 1 et 2µm.

Ces poudres supraconductrices présentent la propriété remarquable de pouvoir donner, après frittage, des matériaux frittés supraconducteurs, parfaitement homogènes, et dont la densité est supérieure à 95 % de la densité théorique du matériau considéré.

La température de frittage des poudres est comprise entre 900°C et 1 000°C, et le temps de frittage généralement compris entre 2 et 10 heures. De préférence, le frittage est réalisé sous atmosphère d'oxygène.

Plus spécifiquement, les caractéristiques des poudres supraconductrices selon l'invention, au regard de leur aptitude au frittage, sont déterminées de la façon suivante :

La poudre est tout d'abord pastillée avec ou sans liant, sous une pression uniaxiale de 1,47.10⁸ N/m (1,5 T/cm), puis frittée pendant 2 heures à une température de 950°C et refroidi en 7 heures jusqu'à température ambiante ; on mesure alors la densité du produit obtenu. Dans tous les cas, on observe une densité finale supérieure à 95 % de la densité théorique du matériau considéré.

D'autre part, on observe que le produit fritté obtenu présente de très bonnes propriétés supraconductrices.

D'autres avantages et aspects de l'invention apparaîtront à la lecture de l'exemple qui suit.

### Exemple

Cet exemple illustre l'invention dans le cadre de la préparation d'un matériau supraconducteur de formule Y-Ba₂-Cu₃-Oₓ (6,5 < x < 7).

### A - Préparation de la poudre

Dans 11,5 l d'eau à 70°C, on introduit 1,5 moles de nitrate d'yttrium, 3 moles de nitrate de baryum et 4,5 moles de nitrate de cuivre.
Après homogénéisation, la solution obtenue est séchée par atomisation.
Le séchage a lieu dans un réacteur de type "flash", tel que décrit dans les brevets français n° 2 257 326, 2 419 754 et 2 431 321.
La température d'entrée des gaz est de 800°C, leur température de sortie de 250°C.
La poudre obtenue après séchage est ensuite calcinée à 900°C sous air pendant un temps compris entre 10 et 15 heures, puis très rapidement ramenée à température ambiante.
Puis, on effectue un broyage à sec jusqu'à l'obtention d'une poudre dont la granulométrie moyenne est inférieure à 2 µm.
Les caractéristiques de la poudre obtenue sont alors les suivantes :
   - surface spécifique (BET) : 2,2 m/g
   - volume poreux total : 0,39 cm³/g
      dont un volume réel : 0,28 cm³/g
      et un volume intergranulaire : 0,11 cm³/g
   - domaine de porosité : 0,1-3 µm
   - diamètre moyen des pores : 0,9 µm
   - granulométrie moyenne : 1,7 µm
   - taille moyenne des cristallites : environ 30 nm (300 Å).
La répartition granulométrique des grains est la suivante (⌀ = diamètre) :
   - ⌀ > 4 µm : 10 %
   - 0,7 µm < ⌀ < 4 µm : 80 %
   - ⌀ < 0,7 µm : 10 %.

### B - Frittage de la poudre

La poudre est pastillée par pressage à sec uniaxial sous une pression de 1,47.10⁸ N/m (1,5 T/cm), puis frittée à 950°C pendant 2 heures sous oxygène et refroidie en 7 heures jusqu'à température ambiante.
On obtient un matériau présentant une densité égale à 96 % de sa densité théorique.
Ce matériau est supraconducteur, sa température "onset" de début de transition est de 92 K et il répond à la formule moyenne Y-Ba₂-Cu₃-0_{6,9}.

## Revendications

1. Procédé de préparation d'une poudre fine supraconductrice à base d'au moins une terre rare, d'au moins un alcalino-terreux, d'un métal de transition et d'oxygène, comprenant les étapes suivantes :
a) on prépare une solution aqueuse à base de nitrates et/ou d'acétates d'au moins une terre rare, d'au moins un alcalino-terreux et d'un métal de transition ;
b) on sèche ladite solution par atomisation en injectant celle-ci suivant une trajectoire confondue avec l'axe de symétrie d'un écoulement hélicoïdal et puits-tourbillon de gaz chauds pulvérisant puis séchant la solution précitée ; le temps de séjour des particules dans le réacteur étant inférieur à 1/10 de seconde environ.
c) on calcine le produit séché
d) on opère éventuellement le broyage de la poudre calcinée.

2. Procédé selon la revendication 1 caractérisé en ce que la température d'entrée desdits gaz chauds est comprise entre 600° et 900°C.

3. Procédé selon la revendication 2 caractérisé en ce que ladite température d'entrée est comprise entre 700° et 900°C.

4. Procédé selon l'une quelconque des revendications 1 à 3 caractérisé en ce que la température de sortie du solide séché est comprise entre 100° et 300°C.

5. Procédé selon la revendication 4 caractérisé en ce que ladite température de sortie est comprise entre 150° et 250°C.

6. Procédé selon l'une quelconque des revendications précédentes caractérisé en ce que ladite calcination s'effectue entre 700°C et 1 000°C, de préférence entre 850°C et 950°C.

7. Procédé selon l'une quelconque des revendications précédentes caractérisé en ce que la calcination s'effectue sous air.

8. Procédé selon l'une quelconque des revendications précédentes caractérisé en ce que ledit broyage s'effectue à sec.

9. Procédé selon la revendication 8 caractérisé en ce que l'on broie les produits calcinés jusqu'à une taille de particules moyenne inférieure à 2 µm (microns) de préférence comprise entre 1 et 2 µm.

10. Procédé selon l'une quelconque des revendications précédentes caractérisé en ce que les terres rares sont choisies parmi l'yttrium et le lanthane.

11. Procédé selon l'une quelconque des revendications précédentes caractérisé en ce que les alcalino-terreux sont choisis parmi le calcium, le baryum et le strontium.

12. Procédé selon l'une quelconque des revendications précédentes caractérisé en ce que les métaux de transition sont choisis parmi le cuivre, le nickel, le manganèse, le cobalt et le fer.

## Patentansprüche

1. Verfahren zur Herstellung eines supraleitenden Feinpulvers auf Basis von mindestens einer Seltenen Erde, mindestens einem Erdalkali, einem Übergangsmetall und Sauerstoff, das die folgenden Schritte umfaßt:
(a) man stellt eine wäßrige Lösung auf Basis von Nitraten und/oder Acetaten von mindestens einer Seltenen Erde, mindestens einem Erdalkali und einem Übergangsmetall her;
(b) man trocknet die Lösung durch Zerstäubung, indem man sie entlang einer Bahn einspritzt, die mit der Symmetrieachse einer schraubenförmigen Strömung und einer zerstäubenden Wirbelschachtströmung heißer Gase zusammenfällt, dann die Lösung trocknet, wobei die Verweildauer der Teilchen in dem Reaktor etwa unterhalb einer Zehntelsekunde liegt,
(c) man calciniert das getrocknete Produkt;
(d) gegebenenfalls zerkleinert man das calcinierte Pulver.

2. Verfahren nach Anspruch 1, dadurch gekennzeichnet, daß die Eintrittstemperatur der heißen Gase zwischen 600 und 900 °c liegt.

3. Verfahren nach Anspruch 2, dadurch gekennzeichnet, daß die Eintrittstemperatur zwischen 700 und 900 °C liegt.

4. Verfahren nach einem der Ansprüche 1 bis 3, dadurch gekennzeichnet, daß die Austrittstemperatur des getrockneten Feststoffs zwischen 100 und 300 °C liegt.

5. Verfahren nach Anspruch 4, dadurch gekennzeichnet, daß die Austrittstemperatur zwischen 150 und 250 °C liegt.

6. Verfahren nach einem der vorangehenden Ansprüche, dadurch gekennzeichnet, daß die Calcinierung bei einer Temperatur zwischen 700 und 1000 °C, vorzugsweise zwischen 850 und 950 °C, durchgeführt wird.

7. Verfahren nach einem der vorhergehenden Ansprüche, dadurch gekennzeichnet, daß die Calcinierung unter Luft durchgeführt wird.

8. Verfahren nach einem der vorhergehenden Ansprüche, dadurch gekennzeichnet, daß die Feinzerkleinerung im trockenen Zustand durchgeführt wird.

9. Verfahren nach Anspruch 8, dadurch gekennzeichnet, daß man die calcinierten Produkte bis zu einer mittleren Teilchengröße unterhalb von 2 µm (Mikron), vorzugsweise zwischen 1 und 2 µm, zerkleinert.

10. Verfahren nach einem der vorhergehenden Ansprüche, dadurch gekennzeichnet, daß die Seltenen Erden ausgewählt sind aus Yttrium und Lanthan.

11. Verfahren nach einem der vorhergehenden Ansprüche, dadurch gekennzeichnet, daß die Erdalkalien ausgewählt sind aus Calcium, Barium und Strontium.

12. Verfahren nach einem der vorhergehenden Ansprüche, dadurch gekennzeichnet, daß die Übergangsmetalle ausgewählt sind aus Kupfer, Nickel, Mangan, Cobalt und Eisen.

## Claims

1. A process for the preparation of a fine superconductive powder comprising at least one rare-earth, at least one alkaline-earth, a transition metal and oxygen, comprising the following steps:
(a) preparing an aqueous solution of nitrates and/or acetates of at least one rare-earth, at least one alkaline-earth and a transition metal;
(b) spray drying said solution by injection along a trajectory which is identical to the axis of symmetry of a helical, vortex-tube stream of hot gases which atomizes then dries said solution; the residence time for the particles in the reactor being less than about 1/10 seconds;
(c) calcining the dried product;
(d) optionally, grinding the calcined powder.

2. A process according to claim 1, characterised in that the inlet temperature for said hot gases is between 600°C and 900°C.

3. A process according to claim 2, characterised in that said inlet temperature is between 700°C and 900°C.

4. A process according to any one of claims 1 to 3, characterised in that the exit temperature for the dried solid is between 100°C and 300°C.

5. A process according to claim 4, characterised in that said exit temperature is between 150°C and 250°C.

6. A process according to any one of the preceding claims, characterised in that said calcination is carried out at between 700°C and 1000°C, preferably between 850°C and 950°C.

7. A process according to any one of the preceding claims, characterised in that calcination is carried out in air.

8. A process according to any one of the preceding claims, characterised in that said grinding is dry grinding.

9. A process according to claim 8, characterised in that the calcined products are ground to an average particle size of less than 2 µm (microns), preferably between 1 and 2 µm.

10. A process according to any one of the preceding claims, characterised in that the rare-earths are selected from yttrium and lanthanum.

11. A process according to any one of the preceding claims, characterised in that the alkaline-earths are selected from calcium, barium and strontium.

12. A process according to any one of the preceding claims, characterised in that the transition metals are selected from copper, nickel, manganese, cobalt and iron.
